# EUROPÄISCHE PATENTSCHRIFT

(11) **EP 2 513 945 B1**
(45) Veröffentlichungstag und Bekanntmachung des Hinweises auf die Patenterteilung: **02.03.2016**
(21) Anmeldenummer: 10790766.9
(22) Anmeldetag: 10.12.2010
(51) Int. Cl.: H01J 37/32, H05B 6/02, H05H 1/46, H02M 1/32

(54) **VERFAHREN ZUM BETRIEB EINES INDUSTRIELLEN PROZESSES**
METHOD FOR OPERATING AN INDUSTRIAL PROCESS
PROCÉDÉ POUR EXÉCUTER UN PROCESSUS INDUSTRIEL

(30) Priorität: 18.12.2009 DE 102009054987
(43) Veröffentlichungstag der Anmeldung: 24.10.2012
(73) Patentinhaber: TRUMPF Hüttinger GmbH + Co. KG, 79111 Freiburg im Breisgau (DE)
(72) Erfinder: THOME, Christian, 79104 Freiburg (DE); GLÜCK, Michael, 79111 Freiburg (DE)
(74) Vertreter: Kohler Schmid Möbus Patentanwälte
(86) Internationale Anmeldenummer: PCT/EP2010/069356
(87) Internationale Veröffentlichungsnummer: WO 2011/073093

(56) Entgegenhaltungen:
- EP-A1- 1 601 015
- EP-A1- 2 037 561
- WO-A1-97/14177
- JP-A- 2004 327 123

## Beschreibung

Die Erfindung betrifft ein Verfahren zum Betrieb einer Plasmaanlage, einer Induktionserwärmungsanlage oder einer Laseranregungsanlage.

Zur Erzeugung von Wechselstromleistung, insbesondere von Hochfrequenzleistung, für industrielle Prozesse, wie Induktionserwärmung oder Plasmaanregung oder Anregung von Gaslasern, werden für hohe Leistungen nach wie vor noch häufig Wechselstromleistungserzeugungsvorrichtungen mit Verstärkerröhren eingesetzt. Gründe dafür sind vor allem die Robustheit der Verstärkerröhren gegenüber schnellen Lastwechseln. Solche Wechselstromleistungserzeugungsvorrichtungen mit Verstärkerröhren weisen aber einen schlechten Wirkungsgrad auf und Verstärkerröhren unterliegen einem Verschleiß. Deswegen versucht man zunehmend, diese Wechselstromleistungserzeugungsvorrichtungen durch solche zu ersetzen, die mit Halbleiterschaltelementen arbeiten. Das können z.B. Transistoren sein. Dabei lassen sich mit derzeit erhältlichen Transistoren Leistungen bis ca. 500W pro Transistor erzeugen. Benötigt werden aber mehrere Kilowatt bis hin zu Megawatt. Um solche Leistungen zu erzeugen, müssen mehrere Transistoren zu Transistormodulen zusammengeschaltet werden, die in Leistungswandlereinheiten eingebaut werden. Zusätzlich müssen mehrere Leistungswandlereinheiten zu Wechselstromleistungserzeugungsvorrichtungen zusammengeschaltet werden. Damit erhöht sich die Anzahl von Transistoren in einer Wechselstromleistungserzeugungsvorrichtung mit jedem geforderten Kilowatt um mindestens zwei Transistoren. Damit erhöhen sich die Forderungen für die Zuverlässigkeit der einzelnen Transistoren um ein Vielfaches, weil jeder ausfallende Transistor zum Stillstand einer gesamten Wechseistromleistungserzeugungsvorrichtung führen kann. In industriellen Prozessen werden Wechselstromleistungserzeugungsvorrichtungen oftmals gepulst betrieben mit zum Teil sehr unterschiedlichen Pulsfrequenzen von Sekundentakt bis hin zu wenigen µs. Dabei werden die Transistoren oftmals mit Hochfrequenzen von über 3 MHz betrieben. Auch eine Modulation der Ausgangsleistung ist ein bekanntes Verfahren in Industrieprozessen. Hierbei wird zum Beispiel bei Induktionserwärmungsprozessen die Ausgangsleistung verändert, wenn bestimmte Temperaturen im Werkstück erreicht worden sind und dann nur noch gehalten oder geringfügig verändert werden sollen. Bei der Bearbeitung von Werkstücken mit Lasern müssen beispielsweise beim Wechseln von zu bearbeitenden Werkstücken die Leistungswandler längere Auszeiten oder Standby-Zeiten, in denen keine Leistung benötigt wird, überbrücken.

Halbleiterschaltelemente, wie zum Beispiel Transistoren, IGBTs, MOSFETs oder aus ihnen aufgebaute Transistormodule, die mit hohen Strömen und damit zur Erzeugung großer Leistungen, zum Beispiel größer 100W, betrieben werden, neigen oftmals zu verfrühten Ausfällen. Insbesondere dann, wenn der Betrieb der Halbleiterschaltelemente mit gepulsten Leistungswechseln erfolgt. Das erklärt sich durch vor allem zwei Phänomene: Erstens die unterschiedlichen Wärmeausdehnungskoeffizienten der bei den Halbleiterschaltelementen verwendeten Materialien (wie z.B.: Substrat, Halbleiterschicht, Bonddrähte). Selbst wenn sich alle Teile des Halbleiterschaltelements gleichmäßig auf eine Temperatur erwärmen würden, so sorgt die unterschiedliche Wärmeausdehnung der Materialien für innere mechanische Spannungen, die mit der Zeit und mit der Dehnungsbewegung durch die Temperaturwechsel zu Bruch und Ausfall führen. Zweitens die unterschiedliche Temperaturverteilung vor allem bei intensiv gekühlten Bauteilen. Bei Leistungserzeugung von mehr als 100W mittels Halbleiterschaltelementen ist es in der Regel unerlässlich die Halbleiterschaltelemente forciert zu kühlen, also z.B. durch Kühlkörper mit forcierter Luftströmung oder durch Flüssigkeitskühlung. Dabei entsteht ein Temperaturgefälle, z.B. von der Halbleiterschicht der Halbleiterschaltelemente bis hin zur Kühlplatte. Das bedeutet, zu den oben beschriebenen Belastungen kommt dann auch noch eine zusätzliche Belastung auf Grund unterschiedlicher Temperaturverteilung. Dabei gibt es auch noch eine nicht einheitliche Temperaturverteilung über die Fläche der Halbleiterschaltelemente, der ebenfalls zu mechanischen Spannungen führt.

Zu Ausfällen von Halbleiterschaltelementen kommt es, wenn Temperaturschwankungen vorliegen. Im Leistungserzeugungsbetrieb werden die Halbleiterschaltelemente warm und es kommt zu den oben beschriebenen Phänomenen. Zwischen zwei Leistungsbetriebsphasen erfolgt jedoch eine Abkühlung, was zu weiteren mechanischen Spannungen führt. Ein ständiger Wechsel zwischen Leistungsbetreib und Pause zwischen zwei Leistungsbetrieben, führt daher ständig zu temperaturbedingten mechanischen Spannungen und Bewegungen.

Aus der EP 2 037 561 A1 ist es bekannt, die Temperatur eines IGBT zu erfassen und den IGBT mit einer geringeren Leistung zu betreiben, wenn die Temperatur einen vorgegebenen Wert erreicht. Sobald die Temperatur ausreichend gefallen ist, kann die Leistung des IGBT's wieder erhöht werden. Während der IGBT mit geringerer Leistung betrieben wird, wird dennoch ein Induktionsheizprozess betrieben. Dies kann dazu führen, dass sich eine Kochdauer verlängert.

Aufgabe der Erfindung ist die Schaffung eines Verfahrens zum Betrieb einer Plasmaanlage, einer Induktionserwärmungsanlage oder einer Laseranregungsanlage unter Verwendung von Halbleiterschaltelementen in einen gepulsten Leistungsabgabebetrieb, wobei die Lebensdauer der Halbleiterschaltelemente erhöht werden soll. Gelöst wird die Aufgabe durch ein Verfahren zum Betrieb einer Plasmaanlage, einer Induktionserwärmungsanlage oder einer Laseranregungsanlage in einem gepulsten Leistungsabgabebetrieb, wobei eine erste Leistung P_{OUT1,1} in einem LeistungsabgabezeitraumΔT₁ erzeugt und an einem Leistungsausgang eines Leistungsgenerators zur Leistungsversorgung eines Plasmaprozesses, eines Induktionserwärmungsprozesses oder eines Laseranregungsprozesses abgegeben wird und in einem PulspausenzeitraumΔT₂ keine für die Zündung oder den Betrieb eines Plasmaprozesses, eines Induktionsprozesses oder eines Laseranregungsprozesses geeignete Leistung P_{OUT2,1} an dem Leistungsausgang des Leistungsgenerators ausgegeben wird, indem zumindest ein Halbleiterschaltelement des Leistungsgenerators angesteuert wird, wobei gleichzeitig zur Erzeugung der ersten Leistung P_{OUT1,1} in dem zumindest einen Halbleiterschaltelement eine erste Verlustleistung P_{V1} während des LeistungsabgabezeitraumsΔT₁ und während des PulspausenzeitraumsΔT₂ eine zweite Verlustleistung P_{V2} in dem zumindest einen Halbleiterschaltelement erzeugt wird, und die erzeugten Verlustleistungen P_{V1}, P_{V2} in Wärme gewandelt werden, wobei eine Absenkung der Temperatur des Halbleiterschaltelements um mehr als einen vorgegebenen Wert durch geeignete Ansteuerung des Halbleiterschaltelements verhindert wird, und sich der Leistungsabgabebetrieb und Pulspausenbetrieb ständig abwechseln.

Es handelt sich also um eine gezielte Erhöhung der Verlustleistung in den Halbleiterschaltelementen immer dann, wenn keine Leistung oder eine so geringe Leistung an den Ausgang geliefert wird, dass kein Plasmaprozess gezündet oder kein Plasmaprozess, Induktionserwärmungsprozess oder Laseranregungsprozess betrieben werden können. Nach herkömmlicher Art würde bei Erzeugung einer ersten Leistung eine erste Verlustleistung in dem Halbleiterschaltelement in Wärme umgewandelt. Geht man davon aus, dass sich der Wirkungsgrad nicht verändert, so wird bei einer Erzeugung einer zweiten niedrigeren Leistung eine proportional niedrigere Verlustleistung in Wärme umgewandelt. Besonders gravierend fällt dies aus, wenn keine Leistung erzeugt wird, dann wird nach herkömmlichen Verfahren auch keine Verlustleistung mehr in Wärme umgewandelt und das Halbleiterschaltelement kühlt sich ab. Beim nächsten Leistungsanstieg, z.B. auf die erste Leistung würde es sich wieder aufwärmen. So kommt es zu für das Halbleiterschaltelement schädlichen Belastungen aufgrund von mechanischen Wärmeausdehnungsspannungen. Mit dem hier beschriebenen Verfahren wird erreicht, dass in den Halbleiterschaltelementen die Verlustleistung und somit die Wärmeentwicklung, die während des Pulspausenzeitraums erzeugt wird, gezielt erhöht wird. Damit verringert sich der Temperaturunterschied zwischen den Leistungswechseln und fällt für die empfindlichen Halbleiterschaltelemente weniger gravierend aus. Dieses Verfahren steht dem Ziel der Maximierung der Effektivität und Minimierung von Verlustleistung entgegen. Das Verfahren bietet trotzdem große Vorteile, weil eine Verringerung der Ausfallraten der Halbleiterschaltelemente sich als anwenderfreundlicher und kostengünstiger herausgestellt hat, als eine weitere Verringerung der Verlustleistung. Außerdem kann an dem Ziel der Verringerung der Verlustleistung weiter erfolgreich gearbeitet werden, indem weiter versucht wird die erste Verlustleistung P_{V1} zu reduzieren. Halbleiterschaltelemente können Transistoren sein wie z.B. IGBTs oder MOSFETs oder Dioden mit Steuereingängen, die von einem leitenden in einen sperrenden Zustand gebracht werden können. Optional können sie auch zumindest kurzzeitig in einen teilweise leitenden Zustand gebracht werden.

Vorzugsweise wird während einer Pulspause, wenn P_{OUT2,1} gleich Null Watt ist, ebenfalls eine zweite Verlustleistung P_{V2}, größer Null erzeugt und in den Halbleiterschaltelementen in Wärme gewandelt.

Das Halbleiterschaltelement oder die Halbleiterschaltelemente können mittels eines Ansteuersignals von einer Ansteuerschaltung angesteuert werden.

Das erfindungsgemäße Verfahren hat den Vorteil, dass industrielle Prozesse in einem gepulsten Leistungsabgabebetrieb betrieben werden können, wobei in einem ersten Zeitintervall eine bestimmte Leistung vom Ausgang gefordert wird und in einem zweite Intervall eigentlich keine Leistung gefordert wird, nämlich dann, wenn das zu bearbeitende Werkstück, beispielsweise bei einem Plasma ein Wafer, eine Compact Disc, ein FPD etc., bei einer Induktionserwärmung das zu erwärmende Werkstück oder bei einem Laser ein Blech gewechselt oder einem anderen Prozess unterzogen wird. Erstes und zweites Intervall wiederholen sich fortlaufend. Dies erfolgt nicht notwendigerweise mit einer festen Frequenz oder mit festgelegten Pulspausen, aber von einer Steuerung vorhersagbar. Mit dem erfindungsgemäßen Verfahren können Temperaturschwankungen an besonders empfindlichen Bauteilen reduziert werden. Insbesondere kann verhindert werden, dass die empfindlichen Bauteile während der Pulspausen, also während derjenigen Intervalle, während denen keine Ausgangsleistung benötigt wird, zu stark abkühlen. Es geht in erster Linie nicht darum, eine gewisse Höchsttemperatur nicht zu überschreiten sondern darum, eine Temperaturabsenkung an besonders empfindlichen Bauteilen im Pulspausenzeitraum zu reduzieren.

Bei einigen industriellen Prozessen kann es jedoch vorteilhaft sein, wenn sich der Leistungsabgabezeitraum und der Pulspausenzeitraum mit einer durch die Plasmaanlage, Induktionserwärmungsanlage oder Laseranregungsanlage vorgegebenen Frequenz fp abwechseln.

Das erfindungsgemäße Verfahren ist grundsätzlich sowohl für industrielle Prozesse, die mit einer Wechselstromleistung versorgt werden, als auch für industrielle Prozesse, die mit einer Gleichstromleistung versorgt werden, anwendbar. Wenn der industrielle Prozess eine Wechselstromleistung erfordert, ist es vorteilhaft, wenn während des Leistungsabgabezeitraums eine Wechselstromleistung bei einer Frequenz fn > fp erzeugt wird. Währen des Leistungsabgabezeitraums wird demnach eine Wechselleistung zugeführt. Am Ausgang eines Leistungsgenerators, in dem die Halbleiterschaltelemente angeordnet sind, wird demnach eine gepulste Wechselstromleistung ausgegeben.

Dabei kann die Frequenz fp im Bereich 0,01Hz - 50kHz liegen.

Die erste Verlustleistung P_{V1} kann aus einem vorgegebenen oder einem gemessenen Wert für die erste Leistung P_{OUT1,1} ermittelt werden, die einzustellende zweite Verlustleistung P_{V2} kann anhand der ermittelten ersten Verlustleistung P_{V1} bestimmt werden, und das zumindest eine Halbleiterschaltelement kann zur Erzeugung der zweiten Verlustleistung P_{V2} angesteuert werden. Damit muss die erste Verlustleistung P_{V1} nicht gemessen werden. Das wäre sehr aufwändig und müsste sehr schnell, also auch in der Nähe des Halbleiterschaltelements erfolgen. P_{V1} kann mittels der Ansteuerschaltung, die die Halbleiterschaltelemente ansteuert, bestimmt werden. Die Ansteuerschaltung kann eingerichtet sein, die erste Leistung einzustellen, wenn sie einen Sollwert für eine erste Leistung P_{OUT1,1} vorgegeben bekommt. Sie kann eingerichtet sein, die dazugehörige Verlustleistung P_{V1} zu bestimmen. Dafür kann sie beispielsweise auf Datentabellen zugreifen oder dies anhand einer Formel berechnen oder anhand einer abgelegten Funktion bestimmen. Für eine zweite vorgegebene Leistung P_{OUT2,1} kann mittels der Ansteuerschaltung anhand der Vorgabe P_{V2}> P_{V1} *(P_{OUT2,1}) die zweite Verlustleistung P_{V2} bestimmt werden und können die Halbleiterschaltelemente entsprechend angesteuert werden, also so, dass P_{V2} und P_{OUT2,1} erzeugt werden. Die Ansteuerschaltung kann auf alle Informationen zugreifen, um P_{V1} einzustellen auch ohne dass eine mit P_{V2} in Bezug stehende Größe gemessen werden muss.

Das Verfahren kann sich dadurch auszeichnen, dass die erste Verlustleistung P_{V1} bestimmt wird, indem ein der ersten Leistung P_{OUT1,1} zugeordneter Wert aus einem Datenspeicher ausgelesen wird. Die Ansteuerschaltung kann sich dadurch auszeichnen dass sie digitale Signale oder analoge und digitale Signale verarbeitet, Daten verarbeitet oder Berechnungen anstellt und so Ansteuersignale generiert, die die Halbleiterschaltelemente ansteuert.

Die zweite Verlustleistung P_{V2} kann in Abhängigkeit von einem oder mehreren der folgenden Werte eingestellt werden:
- Dauer des Leistungsabgabezeitraums
- Dauer des Pulspausenzeitraums
- zeitlicher Verlauf der Leistung
- zeitlicher Verlauf der Verlustleistung in den Halbleiterschaltelementen
- einer ermittelten Temperatur oder eines Temperaturverlaufs
- eines ermittelten Spannungswerts oder Spannungsverlaufs
- eines ermittelten Stromwerts oder Stromverlaufs
- zeitliche Ableitung des Verlaufs der Wechselstromleistung, der Verlustleistung in den Halbleiterschaltelementen, des Temperaturverlaufs, des Spannungsverlaufs oder des Stromverlaufs.

Für die Einstellung der zweiten Verlustleistung P_{V2} kann zum Beispiel die Umgebungstemperatur, z.B. innerhalb eines Gehäuses in der Wechselstromleistungserzeugungsvorrichtung, die Temperatur einer Kühlvorrichtung, zum Beispiel der Kühlplatte oder eines Kühlmediums, oder die Temperatur des Halbleiterschaltelements berücksichtigt werden Als Temperatur des Halbleiterschaltelements kann eine Temperatur in unmittelbarer Nähe, also z.B. direkt auf dem Halbleiterschaltelement, oder in vorgegebener Entfernung, also z.B. auf dem Gehäuse des Halbleiterschaltelements, verwendet werden. Diese Temperaturen können gemessen werden und in Kombination mit der Dauer des ersten oder zweiten Zeitintervalls ebenfalls für die Einstellung der zweiten Verlustleistung P_{V2} verwendet werden. Bei modulierten Signalen kann der zeitliche Verlauf der Leistung, insbesondere einer Wechselstromleistung, einer bestimmten Spannung am Halbleiterschaltelement oder am Ausgang einer Leistungswandlereinheit oder z.B. des Stroms durch das Halbleiterschaltelement für die Einstellung der zweiten Verlustleistung P_{V2} berücksichtigt werden. All die genannten Daten können in einem Speicher abgelegt werden, auf den die Ansteuerschaltung zur Bestimmung der zweiten Verlustleistung P_{V2} zugreifen kann. Die Daten können zyklisch in einem Ringspeicher abgelegt werden und nach einer gewissen Datenmenge überschrieben werden. Dann kann die Ansteuerschaltung immer auf die aktuellsten Daten zugreifen, die für die Einstellung der zweiten Verlustleistung P_{V2} die wesentliche Rolle spielen. All diese Werte können einzeln für sich oder in Kombination untereinander oder mit den bereits genannten Werten für P_{OUT1,1}, P_{OUT2,1}, P_{V1} oder in gewichteter Kombination oder mit ihrer zeitlichen Ableitung für die Beurteilung herangezogen werden.

Die zweite Verlustleistung P_{V2} kann gleich groß sein wie die erste Verlustleistung P_{V1}. Das ist der meistens anzustrebende Fall, weil dann davon ausgegangen werden kann, dass überhaupt kein Temperaturunterschied in den Halbleiterschaltelementen entsteht.

Die zweite Verlustleistung P_{V2} kann gleich groß der ersten Verlustleistung P_{V1} +/- 50% oder +/- 30% oder +/-20% sein. Für die Erreichung des Ziels P_{V2} = P_{V1} muss unter Umständen ein sehr hoher Aufwand betrieben werden. Deswegen ist es unter bestimmten Umständen sinnvoll, die Grenzen für die Einstellung weiter zu fassen. Dies kann auch abhängig von der Umgebungstemperatur oder der Temperatur eines Kühlmediums gemacht werden, weil das Ausfallrisiko für die Halbleiterschaltelemente bei gleicher Temperaturänderung höher ausfallen kann, wenn die absolute Temperatur höher ist. Die Halbleiterschaltelemente derart anzusteuern, dass die zweite Verlustleistung P_{V2} höher als die erste Verlustleistung P_{V1} ist, ist eigentlich nicht sinnvoll, weil hier kein Vorteil für die Ausfallsicherheit zu sehen ist und nachteilig die erhöhte Verlustleistung entsteht. Wenn dies aber innerhalb gewisser Grenzen erfolgt und auf Grund von Ungenauigkeit erfolgt, um gleichzeitig den Aufwand bei der Bestimmung der Verlustleistung gering zu halten, so kann dies trotzdem vorteilhaft sein.

Gemäß einer Verfahrensvariante kann vorgesehen sein, dass das zumindest eine Halbleiterschaltelement während des Leistungsabgabezeitraums ΔT₁ mehrmals sowohl in einen leitenden Zustand, in dem es einen Einschaltwiderstand Rₒₙ aufweist, als auch in einen sperrenden Zustand, in dem es einen Sperrwiderstand R_{off} aufweist, gesteuert wird, und während des Pulspausenzeitraums ΔT₂ zumindest zeitweise in einen teilweise leitenden Zustand geschaltet wird, in dem es einen Übergangswiderstand Rᵥ aufweist, wobei für die Widerstände gilt: Rₒₙ, < Rᵥ und Rᵥ < R_{off}. Üblicherweise wird man versuchen, die Halbleiterschaltelemente möglichst vom leitenden in den nicht leitenden Zustand hin- und her- zuschalten und den dazwischen liegenden teilweise leitenden Zustand so kurz wie möglich zu halten, und dafür zu sorgen, dass so wenig Verlustleistung wie möglich in den Halbleiterschaltelementen entsteht. Denn wenn Rₒₙ sehr gering ist, so wird nur eine geringe Spannung über den Halbleiterschalt-elementen abfallen und die Verlustleistung wird niedrig sein und wenn R_{off} sehr groß ist, dann wird nur ein geringer Strom über die Halbleiterschaltelemente fließen und die Verlustleistung wird ebenfalls gering sein. Um eine nennenswerte Verlustleistung zu erhalten, wie es das Verfahren beschreibt, kann es jedoch sinnvoll sein, die Halbleiterschaltelemente bewusst zumindest zeitweise in einen teilweise leitenden Zustand zu bringen und zu halten. In diesem Zustand kann die Verlustleistung sehr exakt eingestellt werden, wenn der Strom I oder die Spannung U bekannt sind, und der Widerstand Rᵥ entsprechend eingestellt wird, dass sich die Verlustleistung P_{V2} = U²/ Rᵥ oder P_{V2} = I² * Rᵥ einstellt.

Gemäß einer Verfahrensvariante kann vorgesehen sein, dass das zumindest eine Halbleiterschaltelement während dem Pulspausenzeitraum ΔT₂ so angesteuert wird, dass die zweite Leistung P_{OUT2,1} gleich Null ist und die erste Verlustleistung P_{V1} und die zweite Verlustleistung P_{V2} nicht mehr als um den Faktor zwei verschieden sind. Dies stellt einen sehr guten Kompromiss zwischen vertretbarem Aufwand und ausreichender Verringerung des Ausfallrisikos der Halbleiterschaltelemente in einem typischen Anwendungsfall dar.

Weiterhin kann vorgesehen sein, dass das zumindest eine Halbleiterschaltelement während des Leistungsabgabezeitraums ΔT₁ für ein Einschaltzeitintervall ΔTₒₙ₁ in einen leitenden Zustand und für ein Ausschaltzeitintervall ΔT_{off1} in einen sperrenden Zustand gesteuert wird, und dass es während dem Pulspausenzeitraum ΔT₂ für ein Einschaltzeitintervall ΔTₒₙ₂ in einen leitenden Zustand und für ein Ausschaltzeitintervall ΔT_{off2} in einen sperrenden Zustand gesteuert wird und dass ΔTₒₙ₂ kleiner ist als ΔTₒₙ₁. ΔTₒₙ₂ kann so klein gewählt werden, dass die Halbleiterschaltelemente wohl einen Strom führen, aber keine Leistung am Ausgang erzeugen. Das ist technisch möglich, weil beim Einschalten vieler Halbleiterschaltelemente zunächst Ladungsträger innerhalb der Halbleiterschichten umverteilt werden müssen, ehe zum Beispiel ein Stromfluss am Ausgang des Halbleiterschaltelements erkennbar wird oder auch zu einer Spannungsänderung am Ausgang führt. Dieser Strom kann eine Verlustleistung in den Halbleiterschaltelementen bewirken. Diese kann für die Einstellung von P_{V2} genutzt werden. ΔTₒₙ₂ kann aber auch länger, aber immer noch so klein gewählt werden, dass die so erzeugten kurzen Leistungsimpulse am Ausgang des Halbleiterschaltelements von nachfolgenden Ausgangsbeschaltungen, wie zum

Beispiel Filterelementen nicht durchgelassen oder stark bedämpft werden. Wenn ein kurzer Impuls ΔTₒₙ₂ zur Erzeugung der gewünschten Verlustleistung P_{V2} nicht ausreichend ist, können mehrere dieser Impulse mit vorgegebener oder veränderbarer Frequenz erzeugt werden.

Es kann vorgesehen sein, dass während dem Leistungsabgabezeitraum ΔT₁ eine weitere erste Leistung P_{OUT1,2} und während einem Pulspausenzeitraum ΔT2, eine weitere zweite Leistung P_{OUT2,2} erzeugt werden, indem zumindest ein weiteres Halbleiterschaltelement angesteuert wird. Die erste und weitere erste Leistung können jeweils in einer eigenen Leistungswandlereinheit erzeugt werden. Die von mehreren Leistungswandlereinheiten erzeugten Leistungen können zu einer Ausgangsleistung zusammengekoppelt werden. Diese kann an nachfolgende Prozesse geliefert werden. Ein solches Verfahren weist mehrere Vorteile auf. Zunächst können höhere Ausgangsleistungen erzielt werden, insbesondere dann, wenn nicht nur zwei sondern noch weitere Leistungen in Leistungswandlereinheiten erzeugt und zusammengeschaltet werden. Gerade dann ist aber die Ausfallsicherheit extrem wichtig, weil ein Ausfall eines Halbleiterschaltelements den Ausfall der gesamten Leistungserzeugungsvorrichtung zu Folge haben kann. Außerdem bietet eine solches Verfahren den Vorteil, dass z.B. die Halbleiterschaltelements so ansteuerbar sind, dass sie eine erniedrigte Ausgangsleistung erzeugen (z.B. P_{OUT2,1}, P_{OUT2,2}) und gleichzeitig eine nicht um das gleiche Maß erniedrigte Verlustleistung erzeugen (z.B. P_{V2}), was die Aufgabe der Erfindung mit vergleichsweise niedrigem Bauteilaufwand löst. Das funktioniert deswegen, weil man für die Erzeugung der niedrigeren Ausgangsleistung die beiden Halbleiterschaltelemente so ansteuern kann, dass sie sich gegenseitig belasten. Außerdem bietet ein Zusammenschalten über einen Leistungskoppler eine erhöhte Störsicherheit gegenüber reflektierten Leistungen, und die Halbleiterschaltelemente werden damit zusätzlich geschützt.

Das zumindest eine Halbleiterschaltelement und das zumindest eine weitere Halbleiterschaltelement können jeweils nach einem eigenen Ansteuerschema angesteuert werden, wobei sich die Ansteuerschemas unterscheiden. Insbesondere können die Ansteuerschemas während der Erzeugung der Leistung P_{OUT1,1} und P_{OUT1,2} gleich sein, und während der Erzeugung der Leistung P_{OUT2,1} und P_{OUT2,2} ungleich sein. So kann bei gleichem Ansteuerschema eine besonders verlustarme symmetrische Ansteuerung erfolgen und bei ungleichem Ansteuerschema eine unsymmetrische und bewusst verlustreichere Ansteuerung erfolgen. Mögliche Ansteuerschemas können z.B. Pulsweitensteuerung, Phasenverschiebung oder Frequenzvariation sein.

Das Verfahren kann sich dadurch auszeichnen, dass die Halbleiterschaltelemente bei der Erzeugung der Leistung P_{OUT1,1} und P_{OUT1,2} nach einem weiteren ersten Ansteuerschema angesteuert werden und bei der Erzeugung der Leistung P_{OUT2,1} und P_{OUT2,2} nach einem weiteren zweiten Ansteuerschema angesteuert werden, wobei sich die Ansteuerschemas unterscheiden. So kann das weitere erste Ansteuerschema ein besonders geringe Verluste erzeugendes Ansteuerschema sein und das weitere zweite Ansteuerschema gezielte und steuerbare Verluste in den Halbleiterschaltelemente erzeugen. Mögliche Ansteuerschemas können auch hier z.B. Pulsweitensteuerung, Phasenverschiebung oder Frequenzvariation sein.

Das Verfahren kann sich dadurch auszeichnen, dass eine erste Phasenbeziehung zwischen der ersten Leistung P_{OUT1,1} und der ersten weiteren Leistung P_{OUT1,2} eingestellt wird und eine zweite von der ersten abweichende Phasenbeziehung zwischen der zweiten Leistung P_{OUT2,1} und der zweiten weiteren Leistung P_{OUT2,2} eingestellt wird. Mit einem solchen Verfahren kann die zweite Verlustleistung P_{V2} besonders präzise und wiederholgenau erzeugt werden. Es erfordert zwar einen erheblichen Entwicklungs- und Kalibrieraufwand, kann aber sehr universell und zuverlässig eingesetzt werden.

Eine mit der ersten Leistung P_{OUT1,1} in Beziehung stehende Größe kann von einem Messmittel erfasst und auf einen Sollwert geregelt wird. Dies kann zum Beispiel die Ausgangsleistung, die Ausgangsspannung oder der Ausgangsstrom des Leistungswandlers sein.

Für die Beurteilung, ob das erfindungsgemäße Verfahren eingesetzt werden soll, insbesondere gezielt eine Verlustleistung erzeugt werden soll, kann einer der folgenden Werte und/oder eine Kombination von mehreren der folgenden Werten herangezogen werden:
- Dauer des Leistungsabgabezeitraums ΔT₁
- Dauer des Pulspausenzeitraums ΔT₂
- zeitlicher Verlauf der Leistung
- zeitlicher Verlauf der Verlustleistung in den Halbleiterschaltelementen
- einer ermittelten Temperatur oder eines Temperaturverlaufs
- eines ermittelten Spannungswerts oder Spannungsverlaufs
- eines ermittelten Stromwerts oder Stromverlaufs
- zeitliche Ableitung des Verlaufs der Leistung, der Verlustleistung in den Halbleiterschaltelementen, des Temperaturverlaufs, des Spannungsverlaufs oder des Stromverlaufs. Diese Vorgehensweise wird als eigenständige Erfindung betrachtet. So macht es beispielsweise bei sehr kurzen Pulspausen oder sehr geringen Leistungsänderungen keinen Sinn, das erfindungsgemäße, bewusst Verlustleistung erzeugende Verfahren anzuwenden, wohl aber ab einer bestimmten Schwelle, wenn also die Pulspausen eine gewisse Länge überschreiten oder die Leistungsänderungen eine bestimmte Schwelle überschreiten.

Weitere Merkmale und Vorteile der Erfindung ergeben sich aus der nachfolgenden Beschreibung von Ausführungsbeispielen der Erfindung, anhand der Figuren der Zeichnung, die erfindungswesentliche Einzelheiten zeigt, sowie aus den Ansprüchen. Die dort gezeigten Merkmale sind nicht notwendig maßstäblich zu verstehen und derart dargestellt, dass die erfindungsgemäßen Besonderheiten deutlich sichtbar gemacht werden können. Die verschiedenen Merkmale können je einzeln für sich oder zu mehreren in beliebigen Kombinationen bei Varianten der Erfindung verwirklicht sein.

In der schematischen Zeichnung sind Ausführungsbeispiele der Erfindung dargestellt und in der nachfolgenden Beschreibung näher erläutert. Es zeigen:
- Fig. 1: eine Wechselstromleistungserzeugungsvorrichtung;
- Fig. 2: eine Wechselstromleistungserzeugungsvorrichtung mit zwei Leistungswandlereinheiten;
- Fig. 3: eine Wechselstromleistungserzeugungsvorrichtung mit zwei Vollbrücken- Leistungswandlereinheiten und einem 3dB 90° Hybrid Koppler
- Fig. 4: eine Wechselstromleistungserzeugungsvorrichtung mit zwei Halbbrücken;
- Fig. 5a: eine prinzipielle Darstellung der Leistungsverläufe im Pulsbetrieb;
- Fig. 5b: eine prinzipielle Darstellung der Leistungsverläufe im Modulationsbetrieb
- Fig. 6: eine Wechselstromleistungserzeugungsvorrichtung mit zwei Klasse E Invertern.
- Fig.7a, b: zeitliche Verläufe für die Erzeugung von Wechselstromleistung in einem
- und 8a, b: gepulsten Leistungsabgabebetrieb.

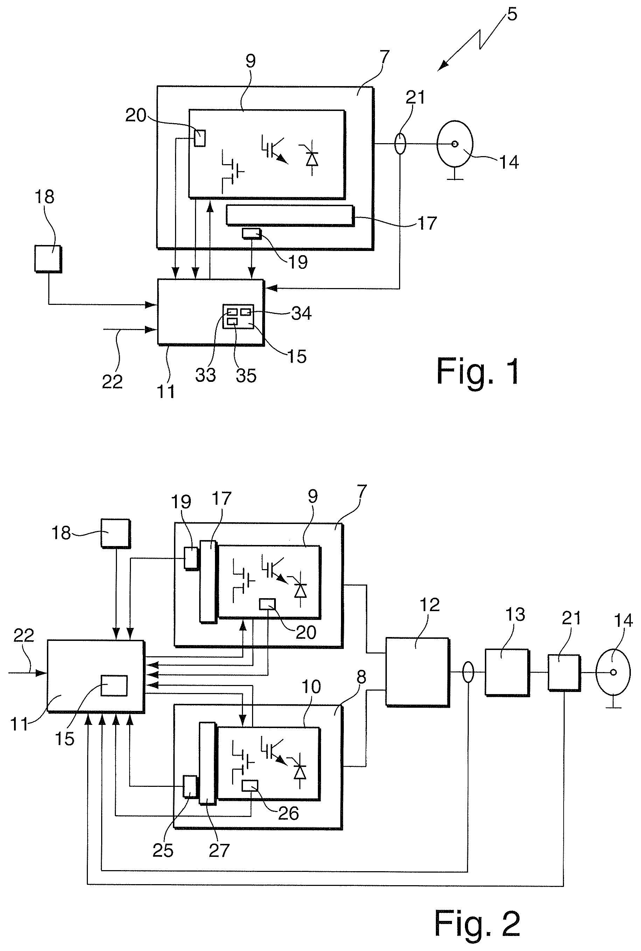

In Fig. 1 ist eine Wechselstromleistungserzeugungsvorrichtung 5 gezeigt, die eine Hochfrequenzleistungserzeugungsvorrichtung sein kann. Sie weist eine Leistungswandlereinheit 7 auf, in der zumindest ein Halbleiterschaltelement 9 angeordnet ist. Dies ist mit drei unterschiedlichen Symbolen für drei häufig verwendete Halbleiterschaltelemente (MOSFET, IGBT, SCR) angedeutet, und soll so verstanden werden, dass hier alle möglichen Halbleiterschaltelemente gemeint sind, die auf unterschiedlichste Weise verschaltet sein können. Die Leistungswandlereinheit 7 kann beispielsweise eine Halbbrücke oder eine Vollbrücke, einen Klasse E-Inverter oder einen Klasse D Inverter aufweisen. Die Halbleiterschaltelemente 9 können mit einer Kühlvorrichtung 17 gekühlt werden.

Dies kann z.B. ein Kühlkörper mit Wärmeabgabe an die Luft oder an ein flüssiges Kühlmedium sein. Die Halbleiterschaltelemente 9 werden von einer Ansteuerschaltung 11 angesteuert. Die erzeugte Leistung, hier eine Wechselstromleistung, insbesondere Hochfrequenzleistung, wird an einen Ausgang 14 der Wechselstromleistungserzeugungsvorrichtung 5 geliefert. Temperaturen können an verschiedenen Punkten gemessen werden. Ein erster Temperaturfühler 18 kann die Umgebungstemperatur im Innern des Gehäuses der Wechselstromleistungserzeugungsvorrichtung 5 messen, ein zweiter Temperaturfühler 19 kann die Temperatur an der Kühlvorrichtung 17 messen, ein dritter Temperaturfühler 20 kann die Temperatur an den Halbleiterschaltelementen 9 messen. Leistung, Spannung und Strom können ebenfalls ermittelt werden, was hier mit dem Messfühler 21 angedeutet ist. Die Messung dieser elektrischen Größen kann am Ausgang 14 der Wechselstromleistungserzeugungsvorrichtung 5 erfolgen oder am Ausgang einer Leistungswandlereinheit 7 oder an einem der Halbleiterschaltelemente 9.

Die Ansteuerschaltung 11 weist eine Überwachungssteuerschaltung 15 auf, die die Ansteuerschaltung 11 beeinflussen kann, um geeignete Ansteuersignale zur Ansteuerung der Halbleiterschaltelemente 9 zu erzeugen. Die Ansteuersignale können erzeugt werden, um die Verlustleistung des oder der Halbleiterschaltelements 9 gezielt zu beeinflussen. Das erfolgt so, dass bei einer ersten Leistungserzeugung und -abgabe, z.B. am Ausgang 14, eine erste Verlustleistung P_{V1} in den Halbleiterschaltelementen 9 in Wärme gewandelt wird. Bei einer zweiten gegenüber der ersten niedrigeren Leistungserzeugung und -abgabe, z.B. am Ausgang 14, wird eine zweite Verlustleistung P_{V2} in den Halbleiterschaltelementen 9 in Wärme gewandelt, für die gilt P_{V2} > P_{V1} *(P_{OUT2,1}/P_{OUT1,1}), wobei P_{OUT2,1} vorzugsweise im Bereich 0W liegt. Mit einer solchen Anordnung bzw. einem solchen Verfahren kann das zumindest eine Halbleiterschaltelement 9 vor frühzeitiger Schädigung durch häufige und/oder hohe Temperaturwechsel geschützt werden. Gleichzeitig ist eine solche Anordnung energiesparend, da die Verlustleistung nur in einem solchen Maße erhöht wird, wie es zur Lösung der Aufgabe nötig ist. Wenn durch entsprechende Maßnahmen oder Vorrichtungen die erste Verlustleistung P_{V1} weiter verringert werden kann, so kann die Ansteuerung entsprechend angeglichen werden um auch die zweite Verlustleistung entsprechend zu verringern.

Der Ansteuerschaltung 11 kann ein Sollwert 22 vorgegeben werden, z.B. zur Steuerung oder Regelung der Ausgangsleistungen am Ausgang 14.

Die Überwachungssteuerschaltung 15 kann eine digitale Datenverarbeitungseinrichtung 33 mit Datenspeicher 34 und Programmspeicher 35 zur Ermittlung der ersten Verlustleistung P_{V1} aus der erste Wechselstromleistung P_{OUT1,1} aufweisen.

Die Überwachungssteuerschaltung 15 muss zur Ermittlung der zweiten Verlustleistung P_{V2} nicht die erste Verlustleistung messtechnisch ermitteln, sondern kann sie mit Hilfe der Datenverarbeitungseinrichtung 33, Datenspeicher 34 und Programmspeicher 35 schnell und sicher aus einem abgelegten Datenbestand ermitteln und die Ansteuerschaltung 11 zur Erzeugung von Ansteuersignalen für die Erzeugung der zweiten Verlustleistung P_{V2} beeinflussen.

Eleganterweise werden der digitalen Datenverarbeitungseinrichtung 33 so viele Aufgaben zur Ermittlung der Verlustleistung P_{V2} und der dafür nötigen Ansteuersignale übertragen, wie sie vom Rechenaufwand in der vorgegebenen Zeit erledigen kann. Auch das Speichern, Laden und Verarbeiten von im Kalibriervorgang oder während des Betriebs ermittelten Daten kann sie übernehmen. Die Geschwindigkeit, mit der die Verlustleistung nachgeregelt werden muss, hängt unter anderem von der Größe der Bauteile, der Temperaturleitfähigkeit und der Kühlung ab. Bei den üblicherweise eingesetzten Bauteilen im Leistungsbereich größer 1kW reicht eine Reaktionszeit von 100µs bis 100 ms aus, um die Bauteile vor Schädigung zu schützen. Für diese Aufgaben kann deswegen eine Datenverarbeitungseinrichtung mit moderater Geschwindigkeit eingesetzt werden, bzw. eine Datenverarbeitungseinrichtung, die noch andere Steuerungsaufgaben übernimmt.

In Fig. 2 wird eine Wechselstromleistungserzeugungsvorrichtung 5 gezeigt, die zwei Leistungswandlereinheiten 7,8 aufweist. Die zweite Leistungswandlereinheit 8 weist ebenfalls zumindest ein Halbleiterschaltelement 10, eine Kühlvorrichtung 27 und Temperaturfühler 25,26 auf. Die Leistungswandlereinheit 8 kann ebenfalls z.B. eine Halbbrücke oder eine Vollbrücke, einen Klasse E Inverter oder einen Klasse D Inverter aufweisen. Die Ausgangsleistungen der Leistungswandlereinheiten 7,8 werden einem Leistungskoppler 12 zugeführt. Dieser Leistungskoppler 12 kann z.B. ein Leistungskoppler (transmission line coupler), ein Wilkinson Koppler oder ein 90° Hybrid Koppler, z.B. ein 3dB Koppler, sein. Es können aber auch andere Techniken der Kopplung beider Leistungen verwendet werden. Ein 90° Hybrid Koppler hat den Vorteil, dass er abhängig von der Phasenlage zweier Eingangssignale diese verkoppelt und phasenabhängig zwei unterschiedlichen Ausgängen zuführt. So kann mittels der Änderung der Phasenlage der Ausgangssignale der beiden Leistungswandler 7,8 (entspricht Eingangssignalen des Kopplers 12) die Verlustleistung in den Halbleiterschaltelementen 9,10 für unterschiedliche Ausgangsleistungen an einem Ausgang des Kopplers nahezu konstant gehalten werden, indem durch die Halbleiterschaltelemente 9,10 konstante Ausgangs- und Verlustleistungen erzeugt werden, die Phasenlage jedoch verändert wird, um am (Leistungs-)Ausgang des Kopplers 12 unterschiedliche Leistungen zu erzeugen. Die Leistung, die an den anderen Ausgang des Kopplers 12 geliefert wird, kann in Gleichstromleistung gewandelt werden und der Wechselstromleistungserzeugungsvorrichtung 5 als Eingangsleistung wieder zur Verfügung gestellt werden. An den Leistungskoppler 12 angeschlossen kann noch eine Aufbereitungsschaltung 13 sein. Das kann zum Beispiel eine Impedanztransformationsvorrichtung oder ein Filter oder eine Überspannungsschutzvorrichtung sein. Außerdem kann noch eine Messvorrichtung 21, z.B. ein Richtkoppler, vorgesehen sein. Diese kann zur Ermittlung der Ausgangsleistung am Ausgang 14, z.B. Vorwärts- und Rückwärtsleistung, oder zur Ermittlung von Strom, Spannung und Phase zwischen Strom und Spannung und damit zur Ermittlung der Impedanz am Ausgang 14 eingesetzt werden. Eine Messung von Spannung und/oder Strom kann auch innerhalb der Leistungswandlereinheiten 7,8, insbesondere an den Halbleiterschaltelementen 9,10, erfolgen. Die erzeugten Messsignale können der Ansteuerschaltung 11 zugeführt werden.

Die verwendeten Halbleiterschaltelemente 9,10 der Leistungswandlereinheiten 7,8 können für ein vorgebbares Zeitintervall in einen teilweise leitenden Zustand versetzbar sein. Mit einer solchen Vorrichtung können die Halbleiterschaltelemente auf einfache Weise und präzise von der Ansteuerschaltung auf ein gewünschtes Verlustleistungsniveau gebracht werden, auch wenn der Widerstand des teilweise leitenden Zustands sich nicht einfach regeln lässt. Um eine über die Zeit gleichmäßig verteilte Verlustwärme zu erzeugen, können die Halbleiterschaltelemente mehrmals für kurze Zeit in den teilweise leitenden Zustand gebracht werden. Daten dazu können im Datenspeicher 34 der Überwachungssteuerschaltung 15 abgelegt sein.

Die Halbleiterschaltelemente 9,10 der Leistungswandlereinheiten 7,8 können in einen teilweise leitenden Zustand versetzbar sein, in der sie einen von der Ansteuerung 11 vorgebbaren Widerstand Rᵥ aufweisen. Mit einer solchen Vorrichtung können die Halbleiterschaltelemente auf einfache Weise und präzise von der Ansteuerschaltung auf ein gewünschtes Verlustleistungsniveau gebracht werden, auch wenn sich die Dauer des teilweise leitenden Zustands sich nicht einfach regeln lässt. Daten dazu können im Datenspeicher 34 der Überwachungssteuerschaltung 15 abgelegt sein.

Die Halbleiterschaltelemente 9,10 der Leistungswandlereinheiten 7,8 können ausgehend von einem sperrenden Zustand in einen Zustand versetzbar sein, in dem sie weiter sperrende Eigenschaften aufweisen und gleichzeitig Umwandlung von Verlustleistung in Wärme stattfindet. Das ist technisch möglich, weil viele Halbleiterschaltelemente 9,10 bei Ansteuerung von einem sperrenden in einen leitenden Zustand eine gewisse Zeit zur Umverteilung von internen Ladungsträgern benötigen. In dieser Zeit bleiben sie im sperrenden Zustand. Die Umverteilung der Ladungsträger erzeugt aber eine Verlustleistung in den Halbleiterschaltelemente 9,10. Mit einer solchen Vorrichtung können die Halbleiterschaltelemente 9,10 auf einfache Weise und präzise von der Ansteuerschaltung auf ein gewünschtes Verlustleistungsniveau gebracht werden. Daten zu diesen Eigenschaften können im Datenspeicher 34 der Überwachungssteuerschaltung 15 abgelegt sein.

Die Halbleiterschaltelemente 9,10 der Leistungswandlereinheiten 7,8 können ausgehend von einem leitenden Zustand in einen Zustand versetzbar sein, in dem sie weiter leitende Eigenschaften aufweisen und gleichzeitig Umwandlung von Verlustleistung in Wärme stattfindet. Das ist technisch möglich, weil viele Halbleiterschaltelemente 9,10 bei Ansteuerung von einem leitenden in einen sperrenden Zustand eine gewisse Zeit zur Umverteilung von internen Ladungsträgern benötigen. In dieser Zeit bleiben sie im leitenden Zustand. Die Umverteilung der Ladungsträger erzeugt aber eine Verlustleistung in den Halbleiterschaltelemente 9,10 Mit einer solchen Vorrichtung können die Halbleiterschaltelemente 9,10 auf einfache Weise und präzise von der Ansteuerschaltung auf ein gewünschtes Verlustleistungsniveau gebracht werden. Daten zu diesen Eigenschaften können im Datenspeicher 34 der Überwachungssteuerschaltung 15 abgelegt sein.

Die Halbleiterschaltelemente 9,10 der Leistungswandlereinheiten 7,8 können für zumindest ein Zeitintervall ΔTₒₙ in einen leitenden Zustand versetzbar sind, das kürzer ist als ein viertel der Periodendauer der von der Wechselstromleistungserzeugungsvorrichtung erzeugten Frequenz. Mit einer solchen Vorrichtung können die Halbleiterschaltelemente 9,10 auf einfache Weise und präzise von der Ansteuerschaltung auf ein gewünschtes Verlustleistungsniveau gebracht werden. Daten dazu können im Datenspeicher 34 der Überwachungssteuerschaltung 15 abgelegt sein.

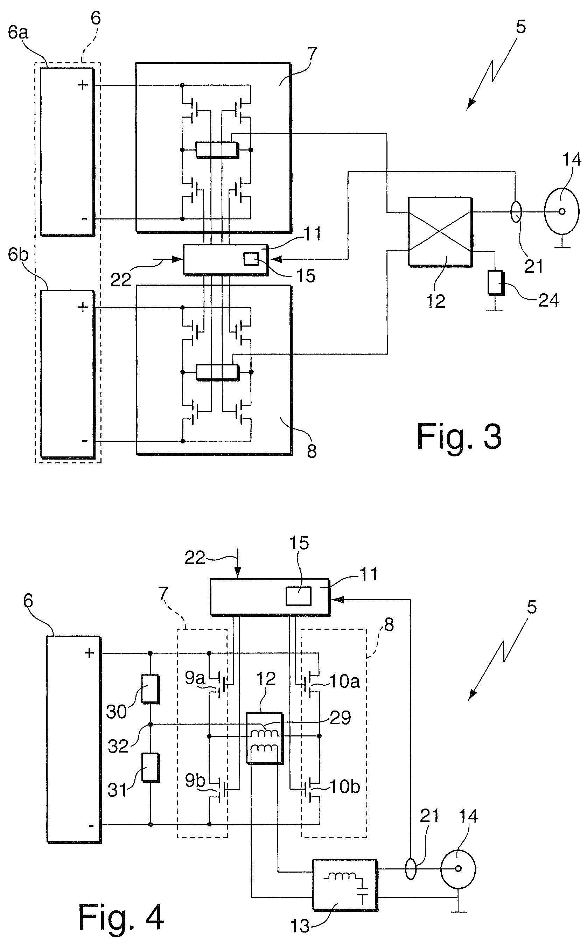

In Fig. 3 ist eine Wechselstromleistungserzeugungsvorrichtung 5, in diesem Fall eine Hochfrequenzleistungserzeugungsvorrichtung mit zwei jeweils als Vollbrücken ausgestalteten Leistungswandlereinheiten 7,8, gezeigt. Die den bereits oben beschriebenen Elementen entsprechenden Elemente sind mit denselben Bezugsziffern nummeriert und werden nicht nochmals erläutert. Der Leistungskoppler 12 ist ein 3dB 90° Hybrid Koppler und an seinen zweiten Ausgang ist ein Ausgleichswiderstand 24 angeschlossen. Zusätzlich sind hier auch Gleichstromversorgungsvorrichtungen 6a, 6b gezeigt, die Teil der Wechselstromleistungserzeugungsvorrichtung 5 sind. Diese können natürlich auch zu einer gemeinsamen Gleichstromversorgungsvorrichtung 6 zusammengefasst werden, die beide Leistungswandlereinheiten 7,8 versorgt. Sie können auch außerhalb der Wechselstromleistungserzeugungsvorrichtung 5 liegen.

In Fig. 4 ist eine weitere Wechselstromleistungserzeugungsvorrichtung 5 gezeigt, in diesem Fall ebenfalls eine Hochfrequenzleistungserzeugungsvorrichtung mit zwei jeweils als Halbbrücken ausgestalteten Leistungswandlereinheiten 7,8. Die den bereits oben beschriebenen Elementen entsprechenden Elemente sind mit denselben Bezugsziffern nummeriert und werden nicht nochmals erläutert. Der Leistungskoppler 12 ist als Transformatoranordnung ausgelegt, mit einer Koppelinduktivität und einer Mittelanzapfung 29. Die Mittelanzapfung 29 ist mit einem Anschlusspunkt 32, zwischen zwei Ausgleichselementen 30, 31 angeschlossen, die mit der Gleichstromversorgung 6 verbunden sind. Auch hier kann durch Veränderung des Ansteuerschemas in den beiden Leistungswandlereinheiten 7,8 die Ausgangsleistung geändert werden und gleichzeitig die Verlustleistung in den Halbleiterschaltelementen 9a,9b,10a,10b gemäß der Erfindung gesteuert werden. So bewirkt ein Verändern der Phase der Ansteuersignale der Halbleiterschaltelemente 9a, 9b gegenüber der Phase der Ansteuersignale der Halbleiterschaltelemente 10a,10b eine Veränderung der Ausgangsleistung am Ausgang 14. Wenn eine hohe Leistung an den Ausgang 14 gelangen soll, so werden die Halbleiterschaltelemente derart angesteuert, dass der Stromfluss alternierend über die Halbleiterschaltelemente 9a, 10b und anschließend über 9b, 10a erfolgt. Wenn eine niedrigere Leistung an den Ausgang 14 gelangen soll, so wird die Phase der Ansteuerung verändert, so dass der Stromfluss zyklisch über die Halbleiterschaltelementen 9a, 10b und anschließend über 9a, 10a, anschließend über 9b, 10a und anschließend über 9b, 10b und dann wieder über 9a, 10b erfolgt. Dies als ,phase shift' - Verfahren bezeichnete Ansteuerschema kann hier bevorzugt zur Steuerung der Verlustleistung in den Halbleiterschaltelementen 9a, 9b, 10a, 10b eingesetzt werden, bei geeigneter Dimensionierung des Leistungskopplers 12 und der Ausgleichselemente 30, 31 im Zusammenspiel mit den Ansteuersignalen. Ein Stromfluss durch die Halbleiterschaltelemente 9a, 10a und 9b, 10b muss zur Erzeugung von Verlustleistung aufrecht erhalten bleiben, auch wenn der Strom durch 9a, 10a bzw. 9b, 10b fließt. Ohne die Ausgleichselemente 30, 31 würde der Strom in der Induktivität, die im Leistungskoppler 12 enthalten ist, schnell abklingen und es würde keine Steuerung der Verlustleistung in den Halbleiterschaltelementen 9a, 10a und 9b 10b möglich sein. Der Stromfluss kann durch die Verbindung des Leistungskopplers 12 zu den Ausgleichselementen 30, 31 aufrecht erhalten werden. Die Ausgleichselemente 30, 31 können zum Beispiel speziell dimensionierte Kondensatoren sein, dann wird in ihnen zumindest theoretisch keine Verlustleistung erzeugt, was sich positiv auf den Energieverbrauch auswirkt.

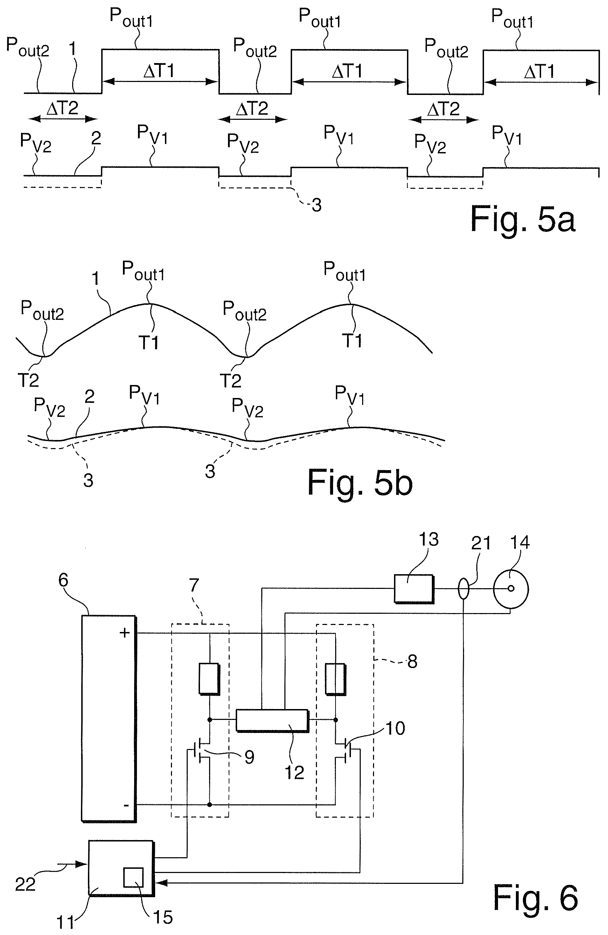

In Fig. 5a und 5b werden typische zeitliche Verläufe für die Erzeugung von Wechselstromleistung und Verlustleistung gezeigt. Der jeweils obere Signalverlauf 1 zeigt schematisch den über die Wechselstromfrequenz gemittelten Betrag eines Wechselstromleistungssignals, wie es am Ausgang einer Leistungswandlereinheit 7,8 oder am Ausgang einer Wechselstromleistungserzeugungsvorrichtung 5 gemessen werden kann. Während einem Leistungsabgabezeitraum ΔT₁ wird eine erste (Wechselstrom)-Leistung P_{OUT1} erzeugt, während einem Pulspausenzeitraum ΔT₂, wird eine zweite (Wechselstrom)-Leistung P_{OUT2} oder keine Leistung erzeugt, wobei P_{OUT1} größer als P_{OUT2} ist. Gleichzeitig werden in dem zumindest einen Halbleiterschaltelement während des Leistungsabgabezeitraums ΔT₁ eine erste Verlustleistung P_{V1} und während des Pulspausenzeitraums ΔT₂ eine zweite Verlustleistung P_{V2} erzeugt, was im jeweils unteren Kurvenverlauf in den Signalverläufen 2 und 3 zu erkennen ist. Der Signalverlauf 2 zeigt schematisch, wie das Verlustleistungssignal bei Betrieb der Wechselstromleistungserzeugungsvorrichtung 5 bei einer erfindungsgemäßen Vorrichtung und Verfahren verlaufen kann. Der gestrichelt gezeichnete Signalverlauf 3 zeigt schematisch, wie das Verlustleistungssignal nach herkömmlichen Verfahren verlaufen würde.

In Fig. 6 ist eine weitere Wechselstromleistungserzeugungsvorrichtung 5 mit zwei jeweils als Klasse E Invertern ausgestalteten Leistungswandlereinheiten 7,8 gezeigt. Die den bereits oben beschriebenen Elementen entsprechenden Elemente sind mit denselben Bezugsziffern nummeriert und werden nicht nochmals erläutert. Klasse E Inverter vereinfachen die Ansteuerschaltung 11, weil alle Ansteuersignale Bezug zur Masse haben.

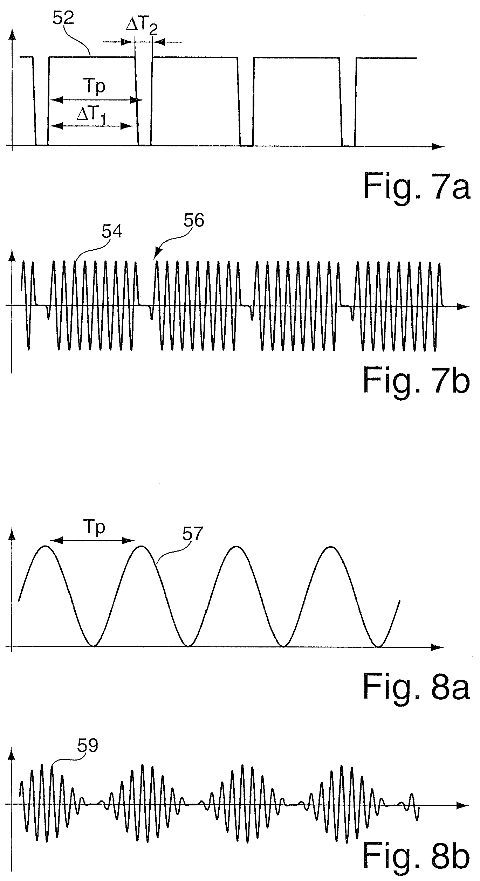

In Fig. 7a und 7b und Fig. 8a, 8b werden typische zeitliche Verläufe für die Erzeugung von Wechselstromleistung gezeigt. Der jeweils obere Signalverlauf 52 in Fig. 7a bzw. 57 in Fig. 8a zeigt schematisch den über die Wechselstromfrequenz gemittelten Betrag eines Wechselstromleistungssignals, wie es am Ausgang einer Leistungswandlereinheit 7, 8 oder am Ausgang einer Wechselstromleistungserzeugungsvorrichtung 5 gemessen werden kann. Der jeweils untere Signalverlauf 54 in Fig. 7b bzw. 59 in Fig. 8b zeigt schematisch die sich im Ausführungsbeispiel mit einer Frequenz fp und Periodendauer Tp=1/fp periodisch ändernde Wechselstromleistung mit der Nutzfrequenz fn, die höher ist als die Pulsperiodendauer Tp=1/fp. Die Nutzfrequenz ist dabei vom industriellen Prozess, der mit Wechselstromleistung versorgt wird, vorgegeben. Hochfrequenzanwendungen, wie die Anregung von industriellen Plasmen oder Gaslasern oder die Versorgung von Induktionserwärmungsprozessen arbeiten bei einer prozessabhängigen vom Anwender vorgegebenen Frequenz. Auch die Frequenz fp kann von dem Prozess vorgegeben sein. Eine erste Wechselstromleistung P_{OUT1,1} kann während einem Leistungsabgabezeitraum ΔT₁ und eine zweite bzw. keine Wechselstromleistung P_{OUT2,1} während einem Pulspausenzeitraum ΔT₂ 56 erzeugt werden. In beiden Zeiträumen wird jeweils eine Verlustleistung P_{V} erzeugt. Es sind auch Prozesse denkbar, bei denen Tp nicht konstant ist sondern sich lediglich die Leistungsabgabezeiträume ΔT₁ und Pulspausenzeiträume ΔT₂ abwechseln. Die Ausgangsleistung P_{OUT} ist auch nicht zwingend eine Wechselstromleistung sondern kann auch eine Gleichstromleistung sein.

## Patentansprüche

1. Verfahren zum Betrieb einer Plasmaanlage, einer Induktionserwärmungsanlage oder einer Laseranregungsanlage in einem gepulsten Leistungsabgabebetrieb, wobei eine erste Leistung P_{OUT1,1} in einem Leistungsabgabezeitraum ΔT₁ erzeugt und an einem Leistungsausgang eines Leistungsgenerators zur Leistungsversorgung eines Plasmaprozesses, eines Induktionserwärmungsprozesses oder eines Laseranregungsprozesses abgegeben wird und in einem Pulspausenzeitraum ΔT₂ keine für die Zündung oder den Betrieb eines Plasmaprozesses, eines Induktionsprozesses oder eines Laseranregungsprozesses geeignete Leistung P_{OUT2,1} an dem Leistungsausgang des Leistungsgenerators ausgegeben wird, indem zumindest ein Halbleiterschaltelement (9, 10, 9a, 9b, 10a, 10b) des Leistungsgenerators angesteuert wird, wobei gleichzeitig zur Erzeugung der ersten Leistung P_{OUT1,1} in dem zumindest einen Halbleiterschaltelement (9, 10, 9a, 9b, 10a, 10b) eine erste Verlustleistung P_{V1} während des Leistungsabgabezeitraums ΔT₁ und während des Pulspausenzeitraums ΔT₂ eine zweite Verlustleistung P_{V2} in dem zumindest einen Halbleiterschaltelement (9, 10, 9a, 9b, 10a, 10b) erzeugt wird, und die erzeugten Verlustleistungen P_{V1}, P_{V2} in Wärme gewandelt werden, wobei eine Absenkung der Temperatur des Halbleiterschaltelements (9, 10, 9a, 9b, 10a, 10b) um mehr als einen vorgegebenen Wert durch geeignete Ansteuerung des Halbleiterschaltelements (9, 10, 9a, 9b, 10a, 10b) verhindert wird, und sich der Leistungsabgabebetrieb und Pulspausenbetrieb ständig abwechseln.

2. Verfahren nach Anspruch 1, **dadurch gekennzeichnet, dass** sich der Leistungsabgabezeitraum ΔT₁ und der Pulspausenzeitraum ΔT₂ mit einer durch die Plasmaanlage, Induktionserwärmungsanlage oder Laseranregungsanlage vorgegebenen Frequenz fp abwechseln.

3. Verfahren nach Anspruch 2, **dadurch gekennzeichnet, dass** fp im Bereich 0,01Hz - 50kHz liegt.

4. Verfahren nach einem der vorhergehenden Ansprüche, **dadurch gekennzeichnet, dass** die erste Verlustleistung P_{V1} aus einem vorgegebenen oder einem gemessenen Wert für die erste Leistung P_{OUT1,1} ermittelt wird, die einzustellende zweite Verlustleistung P_{V2} anhand der ermittelten ersten Leistung P_{V1} bestimmt wird, und das zumindest eine Halbleiterschaltelement (9, 10, 9a, 9b, 10a, 10b) zur Erzeugung der zweiten Verlustleistung P_{V2} angesteuert wird.

5. Verfahren nach einem der vorhergehenden Ansprüche, **dadurch gekennzeichnet, dass** die erste Verlustleistung P_{V1} bestimmt wird, indem ein der Leistung P_{OUT1,1} zugeordneter Wert aus einem Datenspeicher (34) ausgelesen wird.

6. Verfahren nach einem der vorhergehenden Ansprüche, **dadurch gekennzeichnet, dass** die zweite Verlustleistung P_{V2} in Abhängigkeit von einem oder mehreren der folgenden Werte eingestellt wird:
- Dauer des Leistungsabgabezeitraums ΔT₁
- Dauer des Pulspausenzeitraums ΔT₂
- zeitlicher Verlauf der Leistung
- zeitlicher Verlauf der Verlustleistung in den Halbleiterschaltelementen (9, 10, 9a, 9b, 10a, 10b)
- einer ermittelten Temperatur oder eines Temperaturverlaufs
- eines ermittelten Spannungswerts oder Spannungsverlaufs
- eines ermittelten Stromwerts oder Stromverlaufs
- zeitliche Ableitung des Verlaufs der Leistung, der Verlustleistung in den Halbleiterschaltelementen (9, 10, 9a, 9b, 10a, 10b), des Temperaturverlaufs, des Spannungsverlaufs oder des Stromverlaufs

7. Verfahren nach einem der vorhergehenden Ansprüche, **dadurch gekennzeichnet, dass** die zweite Verlustleistung P_{V2} gleich groß der ersten Verlustleistung P_{V1} ist.

8. Verfahren nach einem der vorhergehenden Ansprüche **dadurch gekennzeichnet, dass** das zumindest eine Halbleiterschaltelement (9, 10, 9a, 9b, 10a, 10b,) während des Leistungsabgabezeitraums ΔT₁ mehrmals sowohl in einen leitenden Zustand, in dem es einen Einschaltwiderstand Rₒₙ aufweist, als auch in einen sperrenden Zustand, in dem es einen Sperrwiderstand R_{off} aufweist, gesteuert wird, und während des Pulspausenzeitraums ΔT₂ zumindest zeitweise in einen teilweise leitenden Zustand geschaltet wird, in dem es einen Übergangswiderstand R_{V} aufweist, wobei für die Widerstände gilt: Rₒₙ < Rᵥ und Rᵥ < R_{off}.

9. Verfahren nach einem der vorhergehenden Ansprüche, **dadurch gekennzeichnet, dass** das zumindest eine Halbleiterschaltelement (9, 10, 9a, 9b, 10a, 10b) während dem Leistungsabgabezeitraums ΔT₂ so angesteuert wird, dass die zweite Leistung P_{OUT2,1} gleich Null ist und die erste Verlustleistung P_{V1} und die zweite Verlustleistung P_{V2} nicht mehr als um den Faktor zwei verschieden sind.

10. Verfahren nach einem der vorhergehenden Ansprüche, **dadurch gekennzeichnet, dass** das zumindest eine Halbleiterschaltelement (9, 10, 9a, 9b, 10a, 10b) während des Leistungsabgabezeitraums ΔT₁ für ein Einschaltzeitintervall ΔTₒₙ₁ in einen leitenden Zustand, und für ein Ausschaltzeitintervall ΔT_{off1} in einen sperrenden Zustand, gesteuert wird, und dass es während dem Pulspausenzeitraum ΔT₂ für ein Einschaltzeitintervall ΔTₒₙ₂ in einen leitenden Zustand, und für ein Ausschaltzeitintervall ΔT_{off2} in einen sperrenden Zustand, gesteuert wird und dass ΔTₒₙ₂ kleiner ist als ΔTₒₙ₁.

11. Verfahren nach einem der vorhergehenden Ansprüche, **dadurch gekennzeichnet, dass** während dem Leistungsabgabezeitraum ΔT₁ eine weitere Leistung P_{OUT1,2} und während dem zweiten Pulspausenzeitraum ΔT₂, eine weiters Leistung P_{OUT2,2} erzeugt werden, indem zumindest ein weiteres Halbleiterschaltelement (9, 10, 9a, 9b, 10a, 10b) angesteuert wird.

12. Verfahren nach einem der vorhergehenden Ansprüche, **dadurch gekennzeichnet, dass** das zumindest eine Halbleiterschaltelement (9, 9a, 9b) und das zumindest eine weitere Halbleiterschaltelement (10, 10a, 10b) jeweils nach einem eigenen Ansteuerschema angesteuert werden wobei sich die Ansteuerschemas unterscheiden.

13. Verfahren nach einem der vorhergehenden Ansprüche, **dadurch gekennzeichnet, dass** die Halbleiterschaltelemente (9, 10, 9a, 9b, 10a, 10b) bei der Erzeugung der Leistung P_{OUT1,1} und P_{OUT1,2} nach einem weiteren ersten Ansteuerschema angesteuert werden und bei der Erzeugung der Leistung P_{OUT2,1} und P_{OUT2,2} nach einem weiteren zweiten Ansteuerschema angesteuert werden, wobei sich die Ansteuerschemas unterscheiden.

14. Verfahren nach einem der vorhergehenden Ansprüche, **dadurch gekennzeichnet, dass** eine erste Phasenbeziehung zwischen der ersten Leistung P_{OUT1,1} und der ersten weiteren Leistung P_{OUT1,2} eingestellt wird und eine zweite von der ersten abweichende Phasenbeziehung zwischen der zweiten Leistung P_{OUT2,1} und der zweiten weiteren Leistung P_{OUT2,2} eingestellt wird.

15. Verfahren nach einem der vorhergehenden Ansprüche, **dadurch gekennzeichnet, dass** eine mit der ersten Leistung P_{OUT1,1} in Beziehung stehende Größe von einem Messmittel erfasst und auf einen Sollwert geregelt wird.

## Claims

1. Method for operating a plasma installation, an induction heating installation or a laser excitation installation in a pulsed power output operation, a first power P_{OUT1.1} being produced in a power output time period ΔT₁ and being discharged at a power output of a power generator for supplying power to a plasma process, an induction heating process or a laser excitation process and no power P_{OUT2.1} which is suitable for the ignition or the operation of a plasma process, an induction process or a laser excitation process being output in a pulse pause time period ΔT₂ at the power output of the power generator by at least one semiconductor switching element (9, 10, 9a, 9b, 10a, 10b) of the power generator being controlled, a first power loss P_{V1} being produced in the at least one semiconductor switching element (9, 10, 9a, 9b, 10a, 10b) during the power output time period ΔT₁ at the same time as the first power P_{OUT1.1} is being produced, and a second power loss P_{V2} being produced during the pulse pause time period ΔT₂ in the at least one semiconductor switching element (9, 10, 9a, 9b, 10a, 10b) and the power losses P_{V1}, P_{V2} produced being converted into heat, a reduction of the temperature of the semiconductor switching element (9, 10, 9a, 9b, 10a, 10b) by more than a predetermined value being prevented by means of appropriate control of the semiconductor switching element (9, 10, 9a, 9b, 10a, 10b), and the power output operation and pulse pause operation continuously alternating.

2. Method according to claim 1, **characterised in that** the power output time period ΔT₁ and the pulse pause time period ΔT₂ alternate with a frequency fp predetermined by the plasma installation, induction heating installation or laser excitation installation.

3. Method according to claim 2, **characterised in that** fp is in the range from 0.01 Hz to 50 kHz.

4. Method according to any one of the preceding claims, **characterised in that** the first power loss P_{V1} is established from a predetermined or a measured value for the first power P_{OUT1.1}, the second power loss P_{V2} to be adjusted is determined based on the established first power loss P_{V1} and the at least one semiconductor switching element (9, 10, 9a, 9b, 10a, 10b) is controlled to produce the second power loss P_{V2}.

5. Method according to any one of the preceding claims, **characterised in that** the first power loss P_{V1} is determined by a value which is associated with the power P_{OUT1.1} being read from a data store (34).

6. Method according to any one of the preceding claims, **characterised in that** the second power loss P_{V2} is adjusted based on one or more of the following values:
- duration of the power output time period ΔT₁
- duration of the pulse pause time period ΔT₂
- progress in time of the power
- progress in time of the power loss in the semiconductor switching elements (9, 10, 9a, 9b, 10a, 10b)
- an established temperature or a temperature curve
- an established voltage value or voltage curve
- an established current value or current curve
- time derivative of the curve of the power, the power loss in the semiconductor switching elements (9, 10, 9a, 9b, 10a, 10b), the temperature curve, the voltage curve or the current curve.

7. Method according to any one of the preceding claims, **characterised in that** the second power loss P_{V2} is the same size as the first power loss P_{V1}.

8. Method according to any one of the preceding claims, **characterised in that** the at least one semiconductor switching element (9, 10, 9a, 9b, 10a, 10b) is controlled during the power output time period ΔT₁ several times both into a conductive state, in which it has a switching resistance Rₒₙ, and into a blocking state, in which it has a blocking resistance R_{off} and, during the pulse pause time period ΔT₂, is switched at least temporarily into a partially conductive state, in which it has a transition resistance Rᵥ, the resistances being given by: Rₒₙ < R_{V} and R_{V} < R_{off}.

9. Method according to any one of the preceding claims, **characterised in that** the at least one semiconductor switching element (9, 10, 9a, 9b, 10a, 10b) is controlled during the pulse pause time period ΔT₂ in such a manner that the second power P_{OUT2.1} is equal to zero and the first power loss P_{V1} and the second power loss P_{V2} are different by no more than the factor of two.

10. Method according to any one of the preceding claims, **characterised in that** the at least one semiconductor switching element (9, 10, 9a, 9b, 10a, 10b) is controlled during the power output time period ΔT₁ for a switching-on time range ΔTₒₙ₁ into a conductive state and for a switching-off time range ΔT_{off1} into a blocking state, and **in that** it is controlled during the pulse pause time period ΔT₂ for a switching-on time range ΔTₒₙ₂ into a conductive state and for a switching-off time range ΔT_{off2} into a blocking state, and **in that** ΔTₒₙ₂ is smaller than ΔTₒₙ₁.

11. Method according to any one of the preceding claims, **characterised in that** an additional power P_{OUT1.2} is produced during the power output time period ΔT₁ and an additional power P_{OUT2.2} is produced during the second pulse pause time period ΔT₂, by at least one additional semiconductor switching element (9, 10, 9a, 9b, 10a, 10b) being controlled.

12. Method according to any one of the preceding claims, **characterised in that** the at least one semiconductor switching element (9, 9a, 9b) and the at least one additional semiconductor switching element (10, 10a, 10b) are each controlled in accordance with their own control procedure, the control procedures differing.

13. Method according to any one of the preceding claims, **characterised in that** the semiconductor switching elements (9, 9a, 9b, 10, 10a, 10b) are controlled when producing the power P_{OUT1.1} and P_{OUT1.2} in accordance with another first control procedure and when producing the power P_{OUT2.1} and P_{OUT2.2} in accordance with an additional second control procedure, the control procedures differing.

14. Method according to any one of the preceding claims, **characterised in that** a first phase relationship between the first power P_{OUT.1} and the first additional power P_{OUT1.2} is adjusted and a second phase relationship which differs from the first between the second power P_{OUT2.1} and the second additional power P_{OUT2.2} is adjusted.

15. Method according to any one of the preceding claims, **characterised in that** a power which is related to the first power P_{OUT1.1} is detected by a measuring means and adjusted to a desired value.

## Revendications

1. Procédé pour exploiter une installation à plasma, une installation de chauffage par induction ou une installation d'excitation laser dans un mode de fourniture de puissance par impulsions, dans lequel une première puissance P_{OUT1,1} est générée pendant une période de fourniture de puissance ΔT₁ et fournie à une sortie de puissance d'un générateur de puissance pour l'alimentation en puissance d'un processus à plasma, d'un processus de chauffage par induction ou d'une installation d'excitation laser et, pendant une période de pause d'impulsions ΔT₂, aucune puissance P_{OUT2,1}, appropriée pour l'allumage ou l'exploitation d'un processus à plasma, d'un processus d'induction ou d'un processus d'excitation laser, n'est fournie à la sortie de puissance du générateur de puissance, par la commande d'au moins un élément de commutation à semi-conducteurs (9, 10, 9a, 9b, 10a, 10b) du générateur de puissance, et dans lequel, simultanément à la génération de la première puissance P_{OUT1,1} dans le ou les éléments de commutation à semi-conducteurs (9, 10, 9a, 9b, 10a, 10b), une première puissance dissipée P_{V1} est générée pendant la période de fourniture de puissance ΔT₁ et une deuxième puissance dissipée P_{V2} pendant la période de pause d'impulsions ΔT₂ dans le ou les éléments de commutation à semi-conducteurs (9, 10, 9a, 9b, 10a, 10b), et les puissances dissipées générées P_{V1}, P_{V2} sont transformées en chaleur, une diminution de la température de l'élément de commutation à semi-conducteurs (9, 10, 9a, 9b, 10a, 10b) de plus d'une valeur prédéfinie étant empêchée par une commande adéquate de l'élément de commutation à semi-conducteurs (9, 10, 9a, 9b, 10a, 10b), et le mode de fourniture de puissance et le mode de pause d'impulsions alternant en permanence.

2. Procédé selon la revendication 1, **caractérisé en ce que** la période de fourniture de puissance ΔT₁ et la période de pause d'impulsions ΔT₂ alternent à une fréquence fp prédéfinie par l'installation à plasma, l'installation de chauffage par induction ou l'installation d'excitation laser.

3. Procédé selon la revendication 2, **caractérisé en ce que** fp se situe dans la plage 0,01 Hz - 50 kHz.

4. Procédé selon l'une des revendications précédentes, **caractérisé en ce que** la première puissance dissipée P_{V1} est déterminée à partir d'une valeur prédéfinie ou mesurée de la première puissance P_{OUT1,1}, la deuxième puissance dissipée P_{V2} à régler à partir de la première puissance P_{V1} déterminée, et le ou les éléments de commande à semi-conducteurs (9, 10, 9a, 9b, 10a, 10b) sont commandés pour générer la deuxième puissance dissipée P_{V2}.

5. Procédé selon l'une des revendications précédentes, **caractérisé en ce que** la première puissance dissipée P_{V1} est déterminée en lisant dans une mémoire de données (34) une valeur associée à la puissance P_{OUT1,1}.

6. Procédé selon l'une des revendications précédentes, **caractérisé en ce que** la deuxième puissance dissipée P_{V2} est réglée en fonction d'une ou plusieurs des valeurs suivantes :
- durée de la période de fourniture de puissance ΔT₁
- durée de la période de pause d'impulsions ΔT₂
- variation dans le temps de la puissance
- variation dans le temps de la puissance dissipée dans les éléments de commutation à semi-conducteurs (9, 10, 9a, 9b, 10a, 10b)
- une température ou une variation de température déterminée
- une valeur de tension ou une variation de tension déterminée
- une valeur de courant ou une variation de courant déterminée
- la dérivée dans le temps de la variation de la puissance, de la puissance dissipée dans les éléments de commutation à semi-conducteurs (9, 10, 9a, 9b, 10a, 10b), de la variation de température, de la variation de tension ou de la variation de courant.

7. Procédé selon l'une des revendications précédentes, **caractérisé en ce que** la deuxième puissance dissipée P_{V2} est égale à la première puissance dissipée P_{V1}.

8. Procédé selon l'une des revendications précédentes, **caractérisé en ce que** pendant la période de fourniture de puissance ΔT₁, le ou les éléments de commutation à semi-conducteurs (9, 10, 9a, 9b, 10a, 10b) sont commandés plusieurs fois aussi bien dans un état conducteur, dans lequel ils présentent une résistance de conduction Rₒₙ, que dans un état bloqué, dans lequel ils présentent une résistance de blocage R_{off}, et pendant la période de pause d'impulsions ΔT₂, commutés au moins temporairement dans un état partiellement conducteur, dans lequel ils présentent une résistance de passage Rᵥ, les résistances satisfaisant aux conditions : Rₒₙ < Rᵥ et Rᵥ < R_{off}.

9. Procédé selon l'une des revendications précédentes, **caractérisé en ce que** pendant la période de fourniture de puissance ΔT₂, le ou les éléments de commutation à semi-conducteurs (9, 10, 9a, 9b, 10a, 10b) sont commandés de façon que la deuxième puissance P_{OUT2,1} soit égale à zéro et que la première puissance dissipée P_{V1} et la deuxième puissance dissipée P_{V2} ne diffèrent pas de plus du facteur deux.

10. Procédé selon l'une des revendications précédentes, **caractérisé en ce que** le ou les éléments de commutation à semi-conducteurs (9, 10, 9a, 9b, 10a, 10b) sont commandés pendant la période de fourniture de puissance ΔT₁ dans un état conducteur durant un intervalle de temps de conduction ΔTₒₙ₁ et dans un état bloqué durant un intervalle de temps de coupure ΔT_{off1}, et qu'ils sont commandés pendant la période de pause d'impulsions ΔT₂ dans un état conducteur durant un intervalle de temps de conduction ΔTₒₙ₂ et dans un état bloqué durant un intervalle de temps de coupure ΔT_{off2} et que ΔTₒₙ₂ est plus petit que ΔTₒₙ₁.

11. Procédé selon l'une des revendications précédentes, **caractérisé en ce que** pendant la période de fourniture de puissance Δ_{T1}, une autre puissance P_{OUT1,2} et pendant la deuxième période de pause d'impulsions ΔT₂, une autre puissance P_{OUT2,2} sont générées en commandant au moins un autre élément de commutation à semi-conducteurs (9, 10, 9a, 9b, 10a, 10b).

12. Procédé selon l'une des revendications précédentes, **caractérisé en ce que** le ou les éléments de commutation à semi-conducteurs (9, 9a, 9b) et le ou les autres éléments de commutation à semi-conducteurs (10, 10a, 10b) sont commandés chaque fois par un schéma de commande propre, les schémas de commande étant différents l'un de l'autre.

13. Procédé selon l'une des revendications précédentes, **caractérisé en ce que** les éléments de commutation à semi-conducteurs (9, 10, 9a, 9b, 10a, 10b) sont commandés selon un autre premier schéma de commande lors de la génération de la puissance P_{OUT1,1} et P_{OUT1,2} et selon un autre deuxième schéma de commande lors de la génération de la puissance P_{OUT2,1} et P_{OUT2,2}, les schémas de commande étant différents l'un de l'autre.

14. Procédé selon l'une des revendications précédentes, **caractérisé en ce qu'**une première relation de phase est réglée entre la première puissance P_{OUT1,1} et la première autre puissance P_{OUT1,2} et qu'une deuxième relation de phase, différente de la première, est réglée entre la deuxième puissance P_{OUT2,1} et la deuxième autre puissance P_{OUT2,2}.

15. Procédé selon l'une des revendications précédentes, **caractérisé en ce qu'**une grandeur en relation avec la première puissance P_{OUT1,1} est détectée par un moyen de mesure et régulée sur une valeur de consigne.
